# EUROPÄISCHE PATENTSCHRIFT

(11) **EP 2 347 033 B1**
(45) Veröffentlichungstag und Bekanntmachung des Hinweises auf die Patenterteilung: **15.08.2012**
(21) Anmeldenummer: 09749096.5
(22) Anmeldetag: 04.11.2009
(51) Int. Cl.: C23C 18/12, C07F 3/06

(54) **FORMULIERUNGEN ENTHALTEND EIN GEMISCH VON ZNO-CUBANEN UND SIE EINSETZENDES VERFAHREN ZUR HERSTELLUNG HALBLEITENDER ZNO-SCHICHTEN**
FORMULATIONS CONTAINING A MIXTURE OF ZNO CUBANES AND METHOD FOR PRODUCING SEMICONDUCTING ZNO LAYERS USING SAID FORMULATIONS
FORMULATIONS CONTENANT UN MÉLANGE DE CUBANES DE ZNO, ET PROCÉDÉ LES UTILISANT POUR LA PRÉPARATION DE COUCHES DE ZNO SEMI-CONDUCTRICES

(30) Priorität: 18.11.2008 DE 102008058040
(43) Veröffentlichungstag der Anmeldung: 27.07.2011
(73) Patentinhaber: Evonik Degussa GmbH, 45764 Marl (DE)
(72) Erfinder: THIEM, Heiko, 45721 Haltern am See (DE); STEIGER, Jürgen, 40237 Düsseldorf (DE); MERKULOV, Alexey, 67059 Ludwigshafen (DE); PHAM, Duy Vu, 46049 Oberhausen (DE); AKSU, Yilmaz, 10785 Berlin (DE); SCHUTTE, Stefan, 12305 Berlin (DE); DRIESS, Matthias, 10557 Berlin (DE)
(86) Internationale Anmeldenummer: PCT/EP2009/064584
(87) Internationale Veröffentlichungsnummer: WO 2010/057770

(56) Entgegenhaltungen:
- JP-A- 7 182 939
- JP-A- 2008 088 511
- Sebastian Polarz, Andrey V. Orlov , Ferdi Schüth, An-Hui Lu: "Preparation of High-Surface-Area Zinc Oxide with Ordered Porosity, Different Pore Sizes, and Nanocrystalline Walls" CHEMISTRY A EUROPEAN JOURNAL Bd. 13, 27. September 2006 (2006-09-27), Seiten 592-597, XP002588232 [gefunden am 2010-06-22]
- Todor Hikov, Andre Rittermeier, Maik-Borris Luedemann, Christian Herrmann, Martin Muhler, Roland A. Fischer: "Preparation of ZnO colloids by pyrolysis of [MeZnOiPr]4 in the presence of hexadecylamine and probing the surface chemistry of the nanoparticles by CO/CO2 adsorption studies followed by FTIR" Journal of Materials Chemistry Bd. 18, 4. Juni 2008 (2008-06-04), Seiten 3325-3331, XP002588233 [gefunden am 2010-06-22]

## Beschreibung

Die vorliegende Erfindung betrifft Formulierungen enthaltend ein Gemisch von ZnO-Cubanen, Verfahren zur Herstellung halbleitender ZnO-Schichten, bei denen diese Formulierungen eingesetzt werden, die nach diesem Verfahren erhältlichen ZnO-Schichten, die Verwendung der Formulierungen zur Herstellung elektronischer Bauteile sowie elektronische Bauteile enthaltend die nach dem Verfahren hergestellten ZnO-Schichten.

Wegen der niedrigen Produktionskosten und der leichten Skalierbarkeit steht gedruckte Elektronik im Fokus vieler aktueller Forschungs- und Entwicklungsprojekte, insbesondere im Bereich der Halbleitertechnologie. Dabei ist ein elektronischer Schaltkreis undenkbar ohne Feldeffekttransistoren (FETs), die im Fall gedruckter Elektronik als Dünnschichtfeldeffekttransistoren (TFTs; thin-film field effect transistors) klassifiziert werden können.

Eine wichtige Komponente in jedem Transistor ist das Halbleitermaterial, welches die Schaltparameter, wie z. B. die Spannung, beeinflusst. Wichtige Parameter für Halbleitermaterialien sind die jeweiligen Feldeffektbeweglichkeiten, Verarbeitbarkeiten und Verarbeitungstemperaturen bei der Herstellung.

Wegen seiner Eigenschaften, die denen des Galliumnitrids ähneln, und wegen seiner einfachen und preisgünstigen Herstellung gehört Zinkoxid zu den attraktivsten anorganischen Oxidmaterialien für die Transistorherstellung. Weiterhin wird Zinkoxid wegen seiner hochinteressanten piezoelektrischen und elektromechanischen Eigenschaften auch oft in der Halbleiter-Technologie allgemein (Mater. Sci. Eng. B-Solid State Mater. Adv. Technol. 2001, 80, 383; IEEE Trans. Microw. Theory Tech. 1969, MT17, 957) und in der Elektronik und Optoelektronik eingesetzt. Aufgrund seiner Bandlücke von 3.37 eV bei Raumtemperatur (Klingshirn, Phys. Status Solidi B, 1975, 71, 547) und seiner hohen Excitonenbindungsenergie von 60 meV (Landolt-Börnstein New Series, Group III Vol. 41 B) hat Zinkoxid auch andere weit verbreitete Anwendungen, wie in der Laser-Technologie bei Raumtemperatur.

Die Hall-Beweglichkeit µ_{H} der Elektronen im ZnO-Einkristall beträgt 400 cm²·V⁻¹·s⁻¹, wobei diese Werte bei in praktischen Versuchen hergestellten Schichten bislang nicht erreicht wurden. Epitaktisch, d. h. z. B. mittels Chemical Vapour Deposition (CVD) abgeschiedene oder gesputterte ZnO-Schichten zeigen FET-Beweglichkeiten von 50 bis 155 cm²·V⁻¹·s⁻¹. Aufgrund der bereits erwähnten Vorteile von Druckprozessen wäre es somit wünschenswert, ZnO-Schichten mit möglichst hohen, für den Einsatz in Schaltkreisen geeigneten Ladungsträgerbeweglichkeiten über Druckverfahren herstellen zu können.

Eine Anforderung an Systeme für gedruckte Elektronik, an der die meisten heutzutage bekannten ZnO-Herstellungstechnologien scheitern, ist die gewünschte niedrige Prozessierungstemperatur. Diese sollte unter 300 °C liegen, um für flexible polymerbasierte Substrate geeignet zu sein.

Prinzipiell gibt es zwei Möglichkeiten zur Realisierung gedruckter Elektronik: Partikel-Konzepte und Precursor-Konzepte.

Partikel-basierte Konzepte setzen dabei vor allem auf den Einsatz nanopartikulärer Systeme, wie z. B. ZnO-Nanoröhren (Nano Letters, 2005, 5,12, 2408-2413). Die Nachteile der Partikel-Konzepte liegen zum einen in der kolloidalen Instabilität der eingesetzten Partikel-Dispersionen, die die Verwendung von Dispergieradditiven erforderlich macht, welche wiederum die resultierende Ladungsträgerbeweglichkeit negativ beeinflussen können. Zum anderen stellt der Partikel-Partikel-Widerstand ein Problem dar, da dieser die Beweglichkeit von Ladungsträgern verringert und allgemein den Schichtwiderstand erhöht.

Für den Precursor-Ansatz können prinzipiell verschiede Zn²⁺-Salze zur ZnO-Synthese verwendet werden, z. B. ZnCl₂, ZnBr₂, Zn(OAc)₂, andere Zn-Salze von Carbonsäuren, Zn(NO₃)₂ und Zn(SO₄)₂. Trotz der resultierenden guten Beweglichkeitswerte sind solche Precursoren jedoch für die druckbare Elektronik nicht geeignet, weil die Prozessierungstemperatur immer weit über 350 °C liegt (siehe z.B. J. Am. Chem. Soc. 2007, 129, 2750 - 2751 für die Zersetzung von Zn(OAc)₂ bzw. IEEE Trans., 54, 6, 2007, 1301-1307 für die Zersetzung von ZnCl₂). Durch Einsatz von z.B. Chelatliganden kann die Prozessierungstemperatur zwar verringert werden, ihre Verwendung erweist sich jedoch als nachteilig für die resultierenden Schichten (DE 20 2005 010 697 U1). Im Gegensatz zu den aufgeführten Zinksalzen sind die einfach industriell verfügbaren Dialkylzinkverbindungen, wie z. B. Me₂Zn und Et₂Zn, sehr reaktiv. Gerade aus diesem Grund ist die Prozessierung mit ihnen jedoch sehr aufwendig, und so besteht ein Bedarf an anderen ZnO-Precursoren, die für die druckbare Elektronik gut geeignet sind.

Obwohl die Reaktion zwischen Dialkylzinkverbindungen und Alkoholen seit mehr als 100 Jahren bekannt ist, ist die Aufklärung der Struktur von Produkten erst in den 60er Jahren des letzten Jahrhunderts gelungen. Durch Umsetzung von Dialkylzink mit Alkoholen erhält man eine Alkoxyalkylzinkverbindung, welche meistens in Tetramer- bzw. Cubanform [RZn(OR')]₄ vorliegt, obwohl abhängig von den Substituenten auch andere Oligomerformen, insbesondere [RZn(OR')]ₙ mit n = 2 - 6, denkbar sind (J. Chem. Soc. 1965, 1870 - 1877; J. Chem. Soc. (B) 1966, 1020 - 1024; Chem. Comm. 1966, 194a). Die Cubane können auch aus den Dialkylzinkverbindungen durch die Reaktion mit Sauerstoff und gegebenenfalls Wasser synthetisiert werden, wobei neben den Monocubanen auch Dicubane entstehen können (Inorg. Chem. 2007, 46, 4293 - 4297).

Die ZnO-Cubane finden ihre Anwendung in der organischen Synthese, z.B. bei der Alkoholdehydratation (J. Org. Chem. 1979, 44(8), 1221 - 1232), als Polymerisationsinitiatoren von β-Propiolactonen und als Precursoren für ZnO in der Methanolsynthese (J. Am. Chem. Soc. 2005, 127, 12028 - 12034), bei der Herstellung von ZnO über Chemical Vapour Synthesis (MOCVD; J. Mater. Chem. 1994, 4(8), 1249 - 1253), und bei der Synthese von ZnO-Nanopartikeln über Solvothermalpyrolyse oder CVD (WO 03/014011 A1; Smll 2005, 1 (5), 540 - 552).

JP 07-182939 A beschreibt die Herstellung transparenter ZnO-Filme aus Lösungen von Verbindungen des Typs [R¹Zn(OR²)]₄ in einem organischen Lösemittel, die im wesentlichen durch Aufbringen der Lösung auf ein Substrat und thermisches Härten herstellbar sind (R¹ = R² = Alkyl, Aryl, Aralkyl).

Die beschriebene Umwandlung von ZnO-Cubanen in ZnO führt zu einer Änderung der Filmmorphologie. Dabei ist es jedoch bislang schwierig, bereits bei niedrigen Verarbeitungstemperaturen homogene Filme mit guten Elektronenbeweglichkeiten zu erzeugen.

Es ist somit Aufgabe der vorliegenden Erfindung, gegenüber dem bekannten Stand der Technik Systeme bereitzustellen, mit denen die bestehenden Ansätze zur Herstellung von ZnO aus auf Precursor-basierenden Systemen dahingehend verbessert werden können, dass auch bei niedrigen Verarbeitungstemperaturen homogene, geschlossene ZnO-Schichten mit hohen Elektronenbeweglichkeiten resultieren.

Die vorliegende Aufgabe wird gelöst durch eine Formulierung umfassend a) mindestens zwei verschiedene ZnO-Cubane, von denen i) mindestens ein ZnO-Cuban bei SATP-Bedingungen (SATP = ,Standard ambient temperature and pressure'; 25 °C und 10⁵ Pa) fest vorliegt und ii) mindestens ein ZnO-Cuban bei SATP-Bedingungen flüssig vorliegt, sowie b) mindestens ein Lösemittel.

Wie bereits zuvor ausgeführt, lassen sich die ZnO-Cubane in der erfindungsgemäßen Formulierung jeweils durch die generische Formel [R¹Zn(OR²)]₄ beschreiben. In dieser können R¹ und R² unabhängig voneinander gleich Alkyl, Aryl, Aralkyl, Alkyloxyalkyl, Aryloxyalkyl oder Aralkyloxyalkyl, insbesondere substituiertes oder unsubstituiertes C₁-C₁₀-Alkyl, substituiertes oder unsubstituiertes C₆-C₁₄-Aryl, substituiertes oder unsubstituiertes Aralkyl mit einer substituierten oder unsubstituierten C₆-C₁₄-ArylGruppe und einer oder mehreren substituierten oder unsubstituierten C₁-C₁₀-AlkylGruppe, substituiertes oder unsubstituiertes C₁-C₁₀-Alkyl-oxy-C₁-C₁₀-Alkyl oder substituiertes oder unsubstituiertes C₆-C₁₄-Aryl-oxy-C₁-C₁₀-Alkyl sein, jeweils mit der Maßgabe, dass sich die ZnO-Cubane weiterhin dadurch unterscheiden, dass sie bei SATP-Bedingungen fest bzw. flüssig vorliegen.

Überraschenderweise wurde festgestellt, dass die dieser Erfindung zugrunde liegende Aufgabe mit einer Formulierung enthaltend nur ein ZnO-Cuban nicht realisiert werden kann. So liefern Formulierungen enthaltend nur ein bei SATP-Bedingungen flüssiges ZnO-Cuban sehr homogene Filme, jedoch müssen diese bei verhältnismäßig hohen Temperaturen umgewandelt werden und die Leistung der resultierenden ZnO-Schicht im Bauteil ist eher gering (µ_{FET} = 2x10⁻⁴ cm²/Vs). Im Gegensatz dazu liefern Formulierungen enthaltend nur ein bei SATP-Bedingungen festes ZnO-Cuban keine homogenen Filme und somit auch keine funktionsfähigen Bauteile.

Demgegenüber wurde festgestellt, dass Formulierungen umfassend ein bei SATP-Bedingungen flüssiges und ein bei SATP-Bedingungen festes ZnO-Cuban nicht nur bei niedrigen Temperaturen verarbeitbar sind und dann homogene Filme mit guten Elektronenbeweglichkeiten liefern, sondern dass unter ihrer Verwendung hergestellten Schichten sogar höhere Elektronenbeweglichkeiten als die auf Basis von bei SATP-Bedingungen flüssigen ZnO-Cubane hergestellten Schichten aufweisen.

Das bei SATP-Bedingungen fest vorliegende ZnO-Cuban weist bei einem Druck von 10⁵ Pa einen Zersetzungs- bzw. Schmelzpunkt von > 25 °C auf. Dabei können auch solche fest vorliegenden ZnO-Cubane eingesetzt werden, die sich nicht durch einen Schmelzvorgang in die flüssige Phase überführen lassen, sondern die sich direkt aus dem festen Zustand heraus zersetzen. Bevorzugt einsetzbare fest vorliegende ZnO-Cubane weisen bei diesem Druck einen Zersetzungspunkt im Bereich von 120 - 300 °C, besonders bevorzugt im Bereich von 150 - 250 °C auf. Derartige ZnO-Cubane führen im Gemisch mit bei SATP-Bedingungen flüssigen ZnO-Cubanen überraschenderweise zu besonders guter Filmbildung und lassen sich dennoch bei niedriger Temperatur verarbeiten.

Bevorzugte bei SATP-Bedingungen fest vorliegende ZnO-Cubane lassen sich durch die generische Formel [R¹Zn(OR²)]₄ darstellen, in der R¹ = Me oder Et und R² = t-Bu oder i-Pr ist. Besonders bevorzugt ist das bei SATP-Bedingungen fest vorliegende ZnO-Cuban eine Verbindung ausgewählt aus [MeZn(O-t-Bu)]₄ oder [MeZn(O-i-Pr)]₄.

Das bei SATP-Bedingungen flüssig vorliegende ZnO-Cuban weist bei 10⁵ Pa einen Schmelzpunkt von < 25 °C auf. Besonders bevorzugt weist es bei diesem Druck einen Schmelzpunkt im Bereich von 25 bis -100 °C auf, besonders bevorzugt einen Schmelzpunkt im Bereich von 0 bis -30 °C. Überraschenderweise konnte festgestellt werden, dass die Homogenität der resultierenden Schicht umso besser wird, je niedriger schmelzendes ZnO-Cuban eingesetzt wird.

Bevorzugte bei SATP-Bedingungen flüssig vorliegende ZnO-Cubane lassen sich durch die generische Formel [R¹Zn(OR²)]₄ darstellen, in der R¹ = Me oder Et und R² = CH₂CH₂OCH₃, CH₂CH₂OCH₂CH₃, CH₂OCH₂CH₃, CH₂OCH₃ oder CH₂CH₂CH₂OCH₃ ist. Besonders bevorzugt ist das bei SATP-Bedingungen flüssig vorliegende ZnO-Cuban [MeZn(OCH₂CH₂OCH₃)]₄.

Das mindestens eine bei Normaldruck feste ZnO-Cuban liegt in der erfindungsgemäßen Formulierung bevorzugt in Anteilen von 10 bis 90 Gew.-%, bevorzugt von 30 bis 70 Gew.-%, ganz besonders bevorzugt von 40 bis 60 Gew.-% bezogen auf die Gesamtmasse von festem und flüssigen ZnO-Cuban vor. Die entsprechenden ZnO-Filme sind umso homogener und zeigen umso bessere Leistungen im Bauteil, je mehr sich die jeweiligen Gewichtsprozentanteile von festem und flüssigem ZnO-Cuban bezogen auf ihre Gesamtmasse einem Wert von 50 Gew.-% annähern. Optimal ist das Ergebnis für Formulierungen enthaltend 50 Gew.-% (bezogen auf die Gesamtmasse ZnO-Cuban) bei Normaldruck festem und 50 Gew.-% (bezogen auf die Gesamtmasse ZnO-Cuban) bei Normaldruck flüssigem ZnO-Cuban: es entsteht ein besonders homogener Film, der auch noch eine besonders gute Leistung im Bauteil (µ_{FET} = 10⁻³ cm²/Vs) liefert.

Die Formulierung enthält weiterhin mindestens ein Lösemittel. Dabei kann die Formulierung sowohl mindestens ein Lösemittel als auch ein Gemisch verschiedener Lösemittel enthalten. Vorzugsweise in der erfindungsgemäßen Formulierung einsetzbar sind aprotische Lösemittel, d. h. solche ausgewählt aus der Gruppe der aprotischen unpolaren Lösemittel, d. h. der Alkane, substituierten Alkane, Alkene, Alkine, Aromaten ohne oder mit aliphatischen oder aromatischen Substituenten, halogenierten Kohlenwasserstoffe, Tetramethylsilan, oder der Gruppe der aprotischen polaren Lösemittel, d. h. der Ether, aromatischen Ether, substituierten Ether, Ester oder Säureanhydride, Ketone, tertiäre Amine, Nitromethan, DMF (Dimethylformamid), DMSO (Dimethylsulfoxid) oder Propylencarbonat. Besonders bevorzugt einsetzbare Lösemittel sind Toluol, Xylol, Anisol, Mesitylen, n-Hexan, n-Heptan, Tris-(3,6-dioxaheptyl)-amin (TDA), 2-Aminomethyltetrahydrofuran, Phenetol, 4-Methylanisol, 3-Methylanisol, Methylbenzoat, N-Methyl-2-pyrrolidon (NMP), Tetralin, Ethylbenzoat und Diethylether.

Bevorzugt beträgt die Konzentration der ZnO-Cubane in der Formulierung 5 - 60, besonders bevorzugt 10 - 50, ganz besonders bevorzugt 20 - 40 Gew.-% bezogen auf die Formulierung.

Die erfindungsgemäße Formulierung eignet sich hervorragend zu Herstellung von ZnO-Schichten, ohne dass ihr dafür weitere Additive zugesetzt werden müssen. Nichtsdestotrotz sind die erfindungsgemäßen Formulierungen kompatibel mit verschiedenen Additiven, wie z. B. Substanzen, die selbige gegen Reagglomeration und Sedimentation stabilisieren. In der Regel kann dieses mindestens eine Additiv, abhängig vom Typ, der Zinkoxidkonzentration und der Art der flüssigen Phase der Dispersion in einem Anteil von 0,01 bis 20 Gew.-% bezogen auf die in der Formulierung befindlichen ZnO-Cubane vorliegen. In der Regel wird man einen niedrigen Anteil dieser Stoffe anstreben, da dies positive Auswirkungen auf die Leistungsfähigkeit des elektronischen Bauteiles haben kann. Besonders geeignete Additive sind:
I) Styrenoxidbasiertes Polyalkylenoxid mit statistischer Verteilung oder als Blockcopolymer der allgemeinen Formel (1),

   R¹O(SO)ₐ(EO)_{b}(PO)_{c}(BO)_{d}R² (1),

   wobei
   - R¹: = ein geradkettiger oder verzweigter oder cycloaliphatischer Rest mit 8 bis 13 Kohlenstoffatomen,
   - R²: = Wasserstoff, ein Acylrest, Alkylrest oder Carbonsäurerest mit jeweils 1 bis 8 C-Atomen,
   - SO: = Styrenoxid, EO = Ethylenoxid, PO = Propylenoxid,
   - BO: = Butylenoxid und
   - a: = 1 bis 5,
   - b: = 3 bis 50,
   - c: = 0 bis 3,
   - d: = 0 bis 3 sind, wobei b ≥ a+c+d ist.
   Verbindungen mit a=1 bis 1,9 sind beispielsweise in EP-A-1078946 beschrieben.
II) Ein Phosphorsäureester der allgemeinen Formel (2), 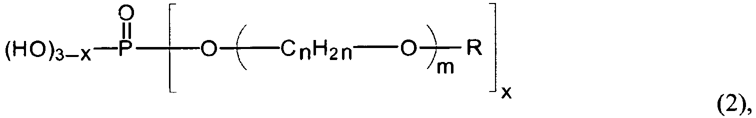 mit R = 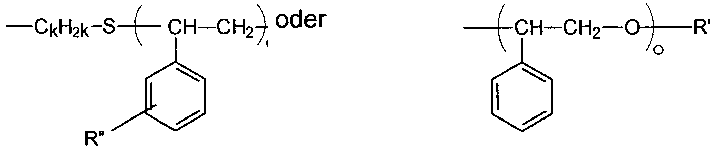 wobei
   - x: = 1 oder 2,
   - n: = 2 bis 18,
   - m, o: = 2 bis 100,
   - k: = 2 bis 4,
   - R": = H oder ein linearer oder verzweigter Alkylrest, der gegebenenfalls mit zusätzlichen funktionellen Gruppen substituiert sein kann, und
   - R': = Alkyl-, Alkaryl-, Alkenyl- oder Sulfopropylrest.
   Bevorzugt eingesetzte Verbindungen sind beispielsweise in EP-A-940406 beschrieben.
III) Weiterhin können Blockcopolymere und deren Salze der allgemeinen Formel (3),

   [R¹O(SO)ₐ(EO)_{b}(CH₂CHCH₃O)_{c}(BO)_{d}]ₓP(=O)(OH)₃₋ₓ (3),

   eingesetzt werden,
   wobei
   - R¹: = ein geradkettiger, verzweigter oder cycloaliphatischer Rest mit 1 bis 22 Kohlenstoffatomen,
   - SO: = Styrenoxid, EO = Ethylenoxid, BO = Butylenoxid und
   - a: = 1 bis < 2,
   - b: = 0 bis 100,
   - c: = 0 bis 10,
   - d: = 0 bis 3 sind, wobei b ≥ a + c + d ist.
IV) Weiterhin können Verbindungen eingesetzt werden, die erhältlich sind durch die teilweise oder vollständige Umsetzung von:
   A) einem oder mehreren aminofunktionellen Polymeren mit
   B) einem oder mehreren Polyestern der allgemeinen Formeln (4)/(4a) T-C(O)-[O-A-C(O)]ₓ-OH (4), T-O-[C(O)-A-O-]_{y}-Z (4a) und
   C) einem oder mehreren Polyethern der allgemeinen Formel (5)/(5a)
      T-C(O)-B-Z (5), T-O-B-Z (5a), worin
      - T ein: Wasserstoffrest und/oder ein gegebenenfalls substituierter, linearer oder verzweigter Aryl-, Arylalkyl-, Alkyl- oder Alkenylrest mit 1 bis 24 Kohlenstoffatomen ist,
      - A: mindestens ein zweiwertiger Rest ist, ausgesucht aus der Gruppe der linearen, verzweigten, cyclischen und aromatischen Kohlenwasserstoffe,
      - Z: mindestens ein Rest ist, ausgesucht aus der Gruppe der Sulfonsäuren, Schwefelsäuren, Phosphonsäuren, Phosphorsäuren, Carbonsäuren, Isocyanate, Epoxide, insbesondere der Phosphorsäure und (Meth)acrylsäure,
      - B: ein Rest der allgemeinen Formel (6) ist -(C₁H₂ₗO)ₐ -(CₘH₂ₘO)_{b} -(CₙH₂ₙO)_{c}-(SO)_{d}- (6)
      - a,b,c: unabhängig voneinander Werte von 0 bis 100 sind, mit der Maßgabe, dass die Summe aus a + b + c ≥ 0, vorzugsweise 5 bis 35, insbesondere 10 bis 20 ist, mit der Maßgabe, dass die Summe aus a+b+c+d>0,
      - d ≥ 0,: vorzugsweise 1 bis 5 ist,
      - l,m,n: unabhängig voneinander ≥ 2, vorzugsweise 2 bis 4 ist,
      - x,y: unabhängig voneinander ≥ 2 sind.
V) Weiterhin können Organopolysiloxane der allgemeinen Formel (7) eingesetzt werden, 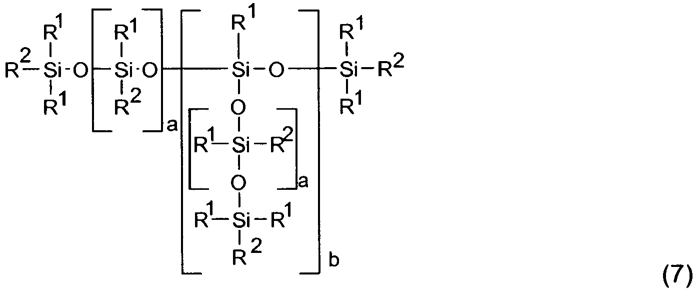 wobei die Reste
   - R¹: Alkylreste mit 1 bis 4 Kohlenstoffatomen oder Arylreste sind, jedoch mindestens 80 % der Reste R¹ Methylreste sind,
   - R²: im Molekül gleich oder verschieden sind und nachfolgende Bedeutungen haben können

   a) 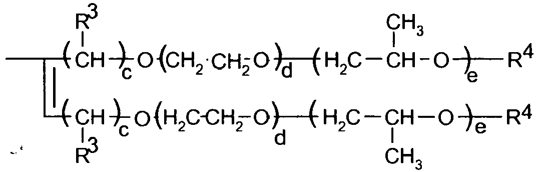 worin
      - R³: ein Wasserstoff-oder Alkylrest,
      - R⁴: ein Wasserstoff-, Alkyl- oder Carboxylrest,
      - c: eine Zahl von 1 bis 20,
      - d: eine Zahl von 0 bis 50,
      - e: eine Zahl von 0 bis 50 ist,
      oder
   b) -(CH₂-)_{f}OR⁵, worin,
      - R⁵: ein Wasserstoff-, Alkyl-, Carboxyl- oder ein gegebenenfalls Ethergruppen enthaltender Dimethylolpropanrest,
      - f: eine Zahl von 2 bis 20 ist
      oder
   c) -(CH₂-)_{g}(OC₂H₄-)ₕ(OC₃H₆-)ᵢ(OC₄H₈)ⱼ(OCH₂CH(C₆H₅))ₖOR⁶ worin
      - R⁶: ein Wasserstoff-, Alkyl- oder Carboxylrest,
      - g: eine Zahl von 2 bis 6,
      - h: eine Zahl von 0 bis 20,
      - i: eine Zahl von 1 bis 50,
      - j: eine Zahl von 0 bis 10,
      - k: eine Zahl von 0 bis 10 ist
      oder
   d) dem Rest R¹ entspricht, mit der Maßgabe, dass im durchschnittlichen Molekül mindestens ein Rest R² die Bedeutung (a) hat, wobei a eine Zahl von 1 bis 500, vorzugsweise 1 bis 200 und insbesondere 1 bis 50 und b eine Zahl von 0 bis 10, vorzugsweise < 5 und insbesondere 0 ist.
   Solche Verbindungen sind beispielsweise in EP-A-1382632 beschrieben.
VI) Weiterhin können Copolymere auf Basis von styrenoxidbasierten Oxyalkylenglykoloder Polyalkylenoxid-Alkenylethern und ungesättigten Carbonsäure-, vorzugsweise Dicarbonsäure-Derivaten eingesetzt werden, mit
   a) 1 bis 80 mol-% mindestens einer der Baugruppen der Formel (8a), (8b), (8c) und/oder (8d) 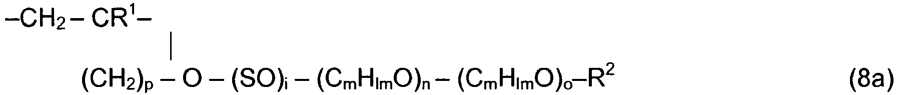 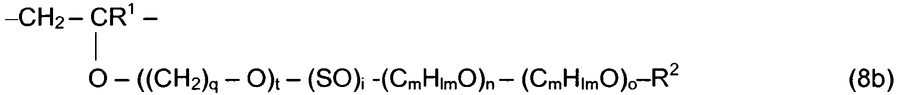 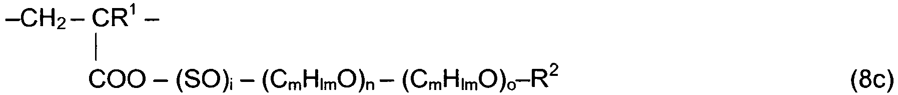 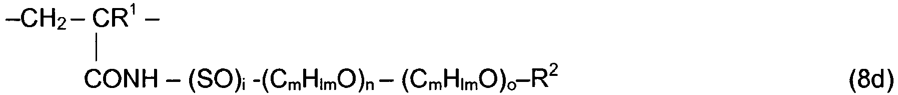 worin
      - R¹: = H, aliphatischer Kohlenwasserstoffrest mit 1 bis 5 C-Atomen,
      - p: = 1-4, q=0-6, t=0-4, i=1-6, l=1-2, m = 2-18 sind,
      wobei der Index am H-Atom durch das Produkt aus l und m gebildet wird, n=0-100, o=0-100, SO = Styrenoxid, wobei (SO)ᵢ und die Alkylenoxidderivate statistisch oder blockartig im Polyether verteilt sein können, bevorzugterweise liegen die Gruppen aber blockartig aufgebaut und in der Reihenfolge
      - (SO)ᵢ - [(CₘHₗₘO)ₙ-(CₘHₗₘO)ₒ] - R² vor.
      - R²=: H, ein aliphatischer, gegebenenfalls verzweigter Kohlenwasserstoffrest mit 1 bis 20 C-Atomen, ein cycloaliphatischer Kohlenwasserstoff mit 5 bis 8 C-Atomen, ein Arylrest mit 6 bis 14 C-Atomen, der gegebenenfalls substituiert ist oder ein Phosphorsäureester-, (vorzugsweise Monoester), Sulfat- oder Sulfonatderivat sein kann.
   b) 1 bis 90 mol-% Baugruppen der Formel (9) 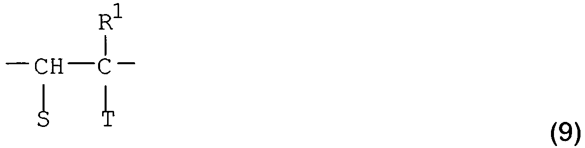 wobei
      - S =: -H, -COOMₐ, -COOR³ bedeutet,
      - M: = Wasserstoff, ein- oder zweiwertiges Metallkation, Ammoniumion, organischer Aminrest,
      - a: = 1 oder für den Fall, dass M ein zweiwertiges Metallkation ½ ist,
      - R³: = ein aliphatischer, gegebenenfalls verzweigter Kohlenwasserstoffrest mit 1 bis 20 C-Atomen, ein cycloaliphatischer Kohlenwasserstoff mit 5 bis 8 C-Atomen, ein Arylrest mit 6 bis 14 C-Atomen ist,
      - T =: -U¹-R⁴ oder -U¹-(CₘHₗₘO)ₙ-(CₘHₗₘO)ₒ-R²,
      - U¹: =-COO-, -CONH-, -CONR³-, -O-, -CH₂O-,
      - R⁴: = H, Mₐ, R³ oder -Q¹-NQ²Q³ ist,
      wobei
      - Q¹: ein zweiwertiger Alkylenrest mit 2 bis 24 Kohlenstoffatomen,
      - Q² und Q³: - aliphatische und/oder alicyclische Alkylreste mit 1 bis 12 Kohlenstoffatomen sind, gegebenenfalls oxidiert zu
      -Q¹-N⁽⁺⁾O⁽⁻⁾Q²Q³
      und
      - m, n, l, o, R¹ und R²: die oben genannte Bedeutung aufweisen,
   c) 0 bis 10 mol-% Baugruppen der Formel (10) 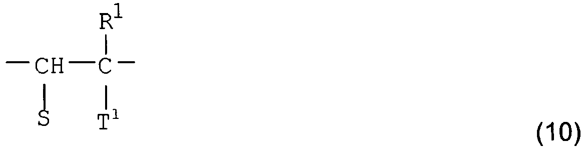 wobei
      - T¹: = -U¹-(CₘHₗₘO)ₙ-(CₘHₗₘO)ₒ-R⁵ bedeutet,

      - R⁵: = R⁴ oder 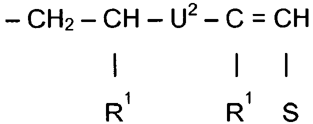
      wobei U² = -OOC -, -NHOC-, -O-, -O-CH₂- ist,
      wobei m, n, l, o, S, R¹, R² und U¹ die oben genannte Bedeutung aufweisen.
   Solche Verbindungen sind beispielsweise in DE-A-10348825 beschrieben.
(VII) Weiterhin können Polyacrylsäuren mit einem gewichtsmittleren Molekulargewicht M_{w} von bevorzugt 200 bis 2 000 000 g/mol, besonders bevorzugt einem M_{w} von 1 000 bis 50 000 g/mol und ihre Salze eingesetzt werden.

Die erfindungsgemäße Formulierung kann weiterhin nicht nur direkt mit oder ohne Zusatz von Additiven zur Herstellung von ZnO-Schichten eingesetzt werden, sondern die Formulierung kann auch eingebettet in Matrixbildner wie z. B. PMMA, Polystyrol, PP, PE, PC oder PVC für die ZnO-Schichtherstellung eingesetzt werden.

Gegenstand der Erfindung ist weiterhin eine Verfahren zur Herstellung einer halbleitenden ZnO-Schicht, bei dem eine erfindungsgemäße Formulierung auf ein Substrat aufgebracht und daran anschließend thermisch konvertiert wird, und die nach diesem Verfahren herstellbaren ZnO-Schichten.

Bei dem Substrat kann es sich um ein Si- oder Si/SiO₂-Wafer, ein Glassubstrat oder ein Polymersubstrat, letztere insbesondere auf der Basis von PET, PE, PEN, PEI, PEEK, Pl, PC, PEA, PA oder PP, handeln.

Das Aufbringen der erfindungsgemäßen Formulierung auf das Substrat kann durch Spin-Coating, Aufsprühen oder verschiedene Druckverfahren (Flexo-Druck, Gravur-Druck, Ink-Jet-Druck, Sieb-Druck, Tampon-Druck oder Offset-Druck) erfolgen. Die thermische Konvertierung erfolgt bevorzugt bei Temperaturen von 120 bis 450 °C, weiter bevorzugt 150 bis 400 °C. Dabei kann die thermische Konvertierung durch den Einsatz von Heizplatten, Öfen, Laser und UV- und/oder Mikrowellenstrahlung Strahlung erfolgen.

Im Anschluss an die thermische Konvertierung kann die aus der erfindungsgemäßen Formulierung hergestellte ZnO-Schicht nachbehandelt werden. So können die Eigenschaften der hergestellten ZnO-Schicht durch eine Nachbehandlung mit reduzierenden bzw. oxidierenden Atmosphären, durch Feuchtigkeit, Plasmabehandlung, Laserbehandlung, UV-Bestrahlung noch weiter verbessert werden.

Die erfindungsgemäßen ZnO-Cuban-Formulierungen können somit zur Herstellung elektronischer Bauteile eingesetzt werden. Insbesondere eignen sich die erfindungsgemäßen ZnO-Cuban-Formulierungen für die Herstellung von Transistoren, optoelektronischen Bauteilen und piezoelektrischer Sensoren.

Gegenstand der vorliegenden Erfindung ist somit ebenfalls ein elektronisches Bauteil, insbesondere ein Transistor, ein optoelektronisches Bauteil und ein piezoelektrischer Sensor, die jeweils mindestens eine halbleitende ZnO-Schicht, die nach den zuvor beschriebenen Verfahren hergestellt wurde, enthalten.

### Beispiele:

### Beispiel 1:

Eine 50/50 Gew.-%-Mischung eines bei SATP-Bedingungen flüssigen ZnO-Cubans ([MeZn(OCH₂CH₂OCH₃)]₄, 400 mg) und eines bei SATP-Bedingungen festen ZnO-Cubans ([MeZn(O-t-Bu)]₄, 400 mg) in 2 mL Toluol wird per Spin-Coating (2000 rpm, 30 s) auf ein Si/SiO₂-Substrat aufgebracht und bei 400 °C in einem Umluftofen ausgeheizt.

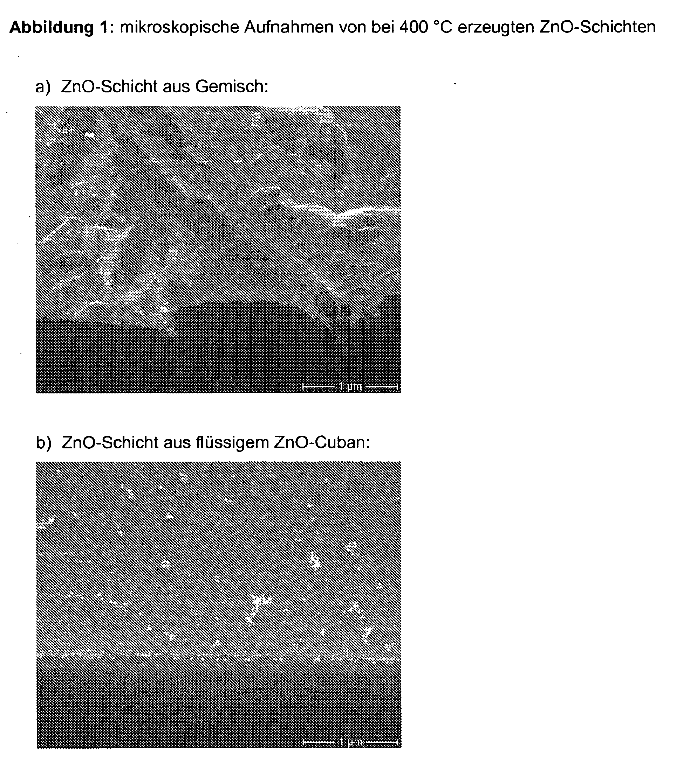

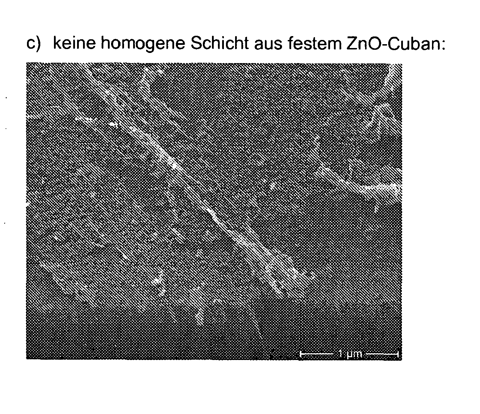

Tabelle 1 zeigt bessere Leistungswerte der resultierenden ZnO-Schicht im TFT gegenüber einer ZnO-Schicht, die unter gleichen Bedingungen aus einer nur das flüssige Cuban enthaltenden, in Bezug auf die Menge an Cuban gleich konzentrierten Lösung hergestellt wurde. Mikroskopische Bilder der resultierenden Schichten zeigt Abbildung 1 (Aufnahmebedingungen SEM: Hitachi S-4000 Mikroskop ausgestattet mit einem SAMX EDX-Detektor ohne Vorbehandlung, mikroskopische Untersuchungen bei Raumtemperatur und Atmosphärendruck). Eine unter gleichen Bedingungen verarbeitete, in Bezug auf die Menge an Cuban gleich konzentrierte Lösung enthaltend nur das feste Cuban bildet, wie aus Abbildung 1c hervorgeht, keine homogene Schicht; Leistungswerte können dort somit nicht ermittelt werden.

### Beispiel 2:

Eine 50/50 Gew.-%-Mischung eines bei SATP-Bedingungen flüssigen ZnO-Cubans ([MeZn(OCH₂CH₂OCH₃)]₄, 400 mg) und eines bei SATP-Bedingungen festen ZnO-Cubans ([MeZn(O-t-Bu)]₄, 400 mg) in 2 mL Toluol wird per Spin-Coating (2000 rpm, 30 s) auf ein Si/SiO₂-Substrat aufgebracht und bei 300 °C in einem Umluftofen ausgeheizt.

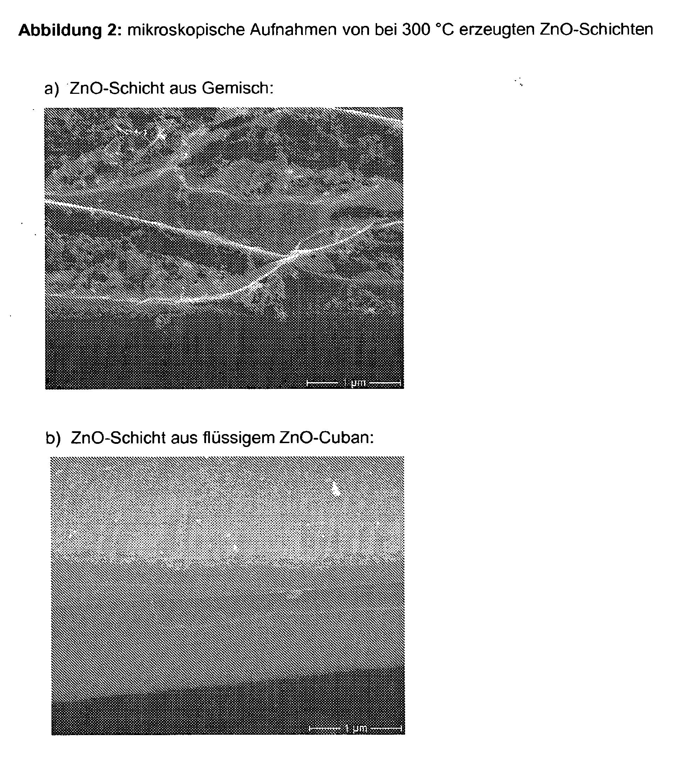

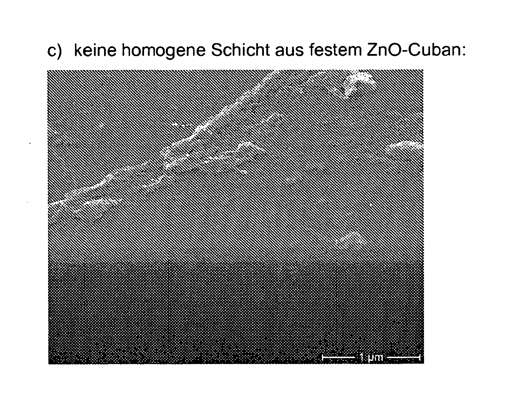

Tabelle 1 zeigt bessere Leistungswerte der resultierenden ZnO-Schicht im TFT gegenüber einer ZnO-Schicht, die unter gleichen Bedingungen aus einer nur das flüssige Cuban enthaltenden, in Bezug auf die Menge an Cuban gleich konzentrierten Lösung hergestellt wurde. Mikroskopische Bilder der resultierenden Schichten zeigt Abbildung 2 (Aufnahmebedingungen SEM: Hitachi S-4000 Mikroskop ausgestattet mit einem SAMX EDX-Detektor ohne Vorbehandlung, mikroskopische Untersuchungen bei Raumtemperatur und Atmosphärendruck). Eine unter gleichen Bedingungen verarbeitete, in Bezug auf die Menge an Cuban gleich konzentrierte Lösung enthaltend nur das feste Cuban bildet, wie aus Abbildung 2c hervorgeht, keine homogene Schicht; Leistungswerte können somit nicht ermittelt werden.

### Beispiel 3:

Eine 50/50 Gew.-%-Mischung eines bei SATP-Bedingungen flüssigen ZnO-Cubans ([MeZn(OCH₂CH₂OCH₃)]₄, 400 mg) und eines bei SATP-Bedingungen festen ZnO-Cubans ([MeZn(O-t-Bu)]₄, 400 mg) in 2 mL Toluol wird per Spin-Coating (2000 rpm, 30 s) auf ein Si/SiO₂-Substrat aufgebracht und bei 200 °C in einem Umluftofen ausgeheizt.

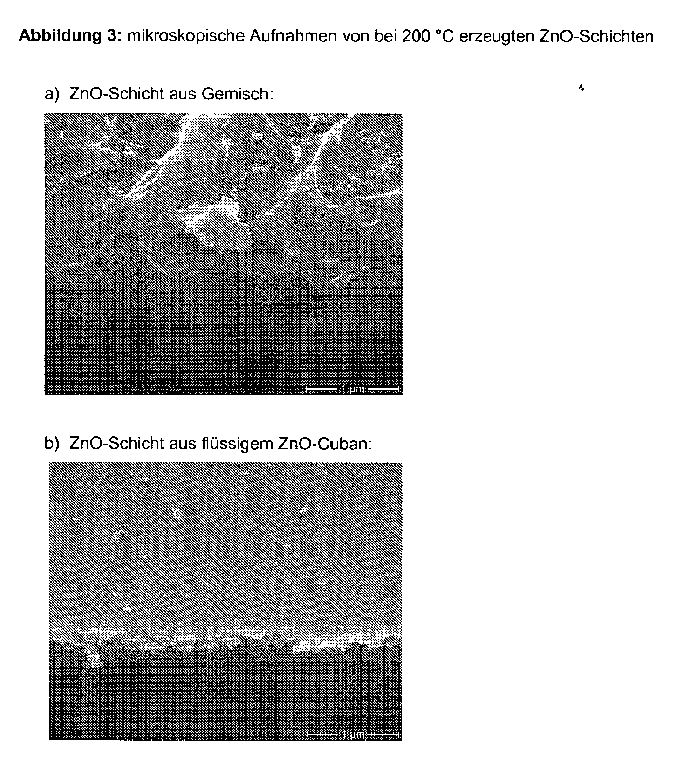

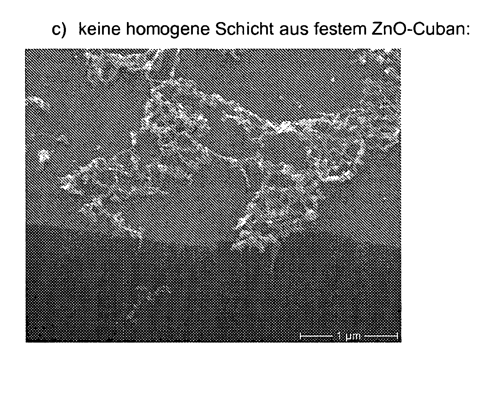

Tabelle 1 zeigt bessere Leistungswerte der resultierenden ZnO-Schicht im TFT gegenüber einer ZnO-Schicht, die unter gleichen Bedingungen aus einer nur das flüssige Cuban enthaltenden, in Bezug auf die Menge an Cuban gleich konzentrierten Lösung hergestellt wurde. Mikroskopische Bilder der resultierenden Schichten zeigt Abbildung 3 (Aufnahmebedingungen SEM: Hitachi S-4000 Mikroskop ausgestattet mit einem SAMX EDX-Detektor ohne Vorbehandlung, mikroskopische Untersuchungen bei Raumtemperatur und Atmosphärendruck). Eine unter gleichen Bedingungen verarbeitete, in Bezug auf die Menge an Cuban gleich konzentrierte Lösung enthaltend nur das feste Cuban bildet, wie aus Abbildung 3c hervorgeht, keine homogene Schicht; Leistungswerte können somit nicht ermittelt werden.

**Tabelle 1:**

| µ_{FET} (10⁻⁴ cm²/Vs) | Gemisch festes/flüssiges ZnO-Cuban | nur flüssiges ZnO-Cuban | nur festes ZnO-Cuban |
|---|---|---|---|
| 400 °C | 10 | 2 | nicht messbar |
| 300 °C | 300 | 6 | nicht messbar |
| 200 °C | 60 | 3 | nicht messbar |

## Patentansprüche

1. Formulierung umfassend
a) mindestens zwei verschiedene ZnO-Cubane von denen
i) mindestens ein ZnO-Cuban bei SATP-Bedingungen fest vorliegt und
ii) mindestens ein ZnO-Cuban bei SATP-Bedingungen flüssig vorliegt, und
b) mindestens ein Lösemittel.

2. Formulierung nach Anspruch 1, **dadurch gekennzeichnet, dass** das bei SATP-Bedingungen fest vorliegende ZnO-Cuban bei 10⁵ Pa einen Zersetzungspunkt von 120 - 300 °C, besonders bevorzugt von 150 - 250 °C aufweist.

3. Formulierung nach Anspruch 1 oder 2, **dadurch gekennzeichnet, dass** das bei SATP-Bedingungen fest vorliegende ZnO-Cuban ein ZnO-Cuban der generischen Formel [R¹Zn(OR²)]₄ mit R¹ = Me oder Et und R² = t-Bu oder i-Pr, insbesondere [MeZn(O-t-Bu)]₄ oder [MeZn(O-i-Pr)]₄ ist..

4. Formulierung nach einem der vorhergehenden Ansprüche, **dadurch gekennzeichnet, dass** das bei SATP-Bedingungen flüssig vorliegende ZnO-Cuban bei Normaldruck einen Schmelzpunkt von 25 bis -100 °C, besonders bevorzugt von 0 bis -30 °C aufweist.

5. Formulierung nach einem der vorhergehenden Ansprüche, **dadurch gekennzeichnet, dass** das bei SATP-Bedingungen flüssig vorliegende ZnO-Cuban ein ZnO-Cuban der generischen Formel [R¹Zn(OR²)]₄ mit R¹ = Me oder Et und R² =CH₂CH₂OCH₃, CH₂CH₂OCH₂CH₃, CH₂OCH₂CH₃, CH₂OCH₃ oder CH₂CH₂CH₂OCH₃, insbesondere MeZn(OCH₂CH₂OCH₃)]₄ist.

6. Formulierung nach einem der vorhergehenden Ansprüche, **dadurch gekennzeichnet, dass** das mindestens eine bei Normaldruck feste ZnO-Cuban in Anteilen von 10 bis 90 Gew.-%, bevorzugt von 30 bis 70 Gew.-%, ganz besonders bevorzugt von 40 bis 60 Gew.-% bezogen auf die Gesamtmasse von festem und flüssigen ZnO-Cuban vorliegt.

7. Formulierung nach einem der vorhergehenden Ansprüche, **dadurch gekennzeichnet, dass** das mindestens ein Lösemittel ausgewählt aus der Gruppe der aprotischen Lösemittel; besonders bevorzugt ausgewählt aus der Gruppe bestehend aus Toluol, Xylol, Anisol, Mesitylen, n-Hexan, n-Heptan, Tris-(3,6-dioxaheptyl)-amin (TDA), 2-Aminomethyltetrahydrofuran, Phenetol, 4-Methylanisol, 3-Methylanisol, Methylbenzoat, N-Methyl-2-pyrrolidon (NMP), Tetralin, Ethylbenzoat und Diethylether ist.

8. Formulierung nach einem der vorhergehenden Ansprüche, **dadurch gekennzeichnet, dass** die Konzentration der ZnO-Cubane 5 - 60, besonders bevorzugt 10 - 50, ganz besonders bevorzugt 20 - 40 Gew.-% bezogen auf die Formulierung beträgt.

9. Formulierung nach einem der vorhergehenden Ansprüche, **dadurch gekennzeichnet, dass** sie weiterhin 0,1 - 20 Gew.-% mindestens eines Additivs bezogen auf die in der Formulierung befindlichen ZnO-Cubane enthält.

10. Verfahren zur Herstellung einer halbleitenden ZnO-Schicht, **dadurch gekennzeichnet, dass** eine Formulierung nach den Ansprüchen 1 bis 9 auf ein Substrat aufgebracht und daran anschließend thermisch, insbesondere bei Temperaturen von 120 bis 450 °C, konvertiert wird.

11. Verfahren nach Anspruch 10, **dadurch gekennzeichnet, dass** das Substrat ein Sioder Si/SiO₂-Wafer, ein Glassubstrat oder ein Polymersubstrat, letzteres bevorzugt auf der Basis von PET, PE, PEN, PEI, PEEK, Pl, PC, PEA, PA oder PP, ist.

12. Verfahren nach Anspruch 10 oder 11, **dadurch gekennzeichnet, dass** das Aufbringen der Formulierung auf das Substrat durch Spin-Coating, Aufsprühen, Flexo-Druck, Gravur-Druck, Ink-Jet-Druck, Sieb-Druck, Tampon-Druck oder Offset-Druck erfolgt.

13. Verfahren nach einem der Ansprüche 10 bis 12, **dadurch gekennzeichnet, dass** die halbleitende ZnO-Schicht durch mindestens einen Verfahrensschritt ausgewählt aus einer Nachbehandlung mit reduzierenden bzw. oxidierenden Atmosphären, Behandlung mit Feuchtigkeit, Plasmabehandlung, Laserbehandlung und UV-Bestrahlung nachbehandelt wird.

14. Verwendung einer Formulierung nach einem der Ansprüche 1 bis 9 zur Herstellung elektronischer Bauteile, insbesondere zur Herstellung von Transistoren, optoelektronischen Bauteilen und Sensoren.

15. Elektronisches Bauteil, enthaltend mindestens eine halbleitende ZnO-Schicht, die nach einem der Verfahren nach den Ansprüchen 10 bis 13 hergestellt wurde.

## Claims

1. Formulation comprising
a) at least two different ZnO cubanes of which
i) at least one ZnO cubane is present in solid form under SATP conditions and
ii) at least one ZnO cubane is present in liquid form under SATP conditions, and
b) at least one solvent.

2. Formulation according to Claim 1, **characterized in that** the ZnO cubane present in solid form under SATP conditions, at 10⁵ Pa, has a decomposition point of 120-300°C, more preferably of 150-250°C.

3. Formulation according to Claim 1 or 2, **characterized in that** the ZnO cubane present in solid form under SATP conditions is a ZnO cubane of the generic formula [R¹Zn(OR²)]₄ where R¹ = Me or Et and R² = t-Bu or i-Pr, especially [MeZn(O-t-Bu)]₄ or [MeZn(O-i-Pr)]₄.

4. Formulation according to any one of the preceding claims, **characterized in that** the ZnO cubane present in liquid form under SATP conditions, at standard pressure, has a melting point of 25 to -100°C, more preferably of 0 to -30°C.

5. Formulation according to any one of the preceding claims, **characterized in that** the ZnO cubane present in liquid form under SATP conditions is a ZnO cubane of the generic formula [R¹Zn(OR²)]₄ where R¹ = Me or Et and R² = CH₂CH₂OCH₃, CH₂CH₂OCH₂CH₃, CH₂OCH₂CH₃, CH₂OCH₃ or CH₂CH₂CH₂OCH₃, especially [MeZn(OCH₂CH₂OCH₃)]₄.

6. Formulation according to any one of the preceding claims, **characterized in that** the at least one ZnO cubane which is solid at standard pressure is present in proportions of 10 to 90% by weight, preferably of 30 to 70% by weight, most preferably of 40 to 60% by weight, based on the total mass of solid and liquid ZnO cubane.

7. Formulation according to any one of the preceding claims, **characterized in that** the at least one solvent is selected from the group of the aprotic solvents, more preferably from the group consisting of toluene, xylene, anisole, mesitylene, n-hexane, n-heptane, tris-(3,6-dioxaheptyl)amine (TDA), 2-aminomethyltetrahydrofuran, phenetole, 4-methylanisole, 3-methylanisole, methyl benzoate, N-methyl-2-pyrrolidone (NMP), tetralin, ethyl benzoate and diethyl ether.

8. Formulation according to any one of the preceding claims, **characterized in that** the concentration of the ZnO cubanes is 5-60, more preferably 10-50 and most preferably 20-40% by weight, based on the formulation.

9. Formulation according to any one of the preceding claims, **characterized in that** it further contains 0.1-20% by weight of at least one additive based on the ZnO cubanes present in the formulation.

10. Process for producing a semiconductive ZnO layer, **characterized in that** a formulation according to any of Claims 1 to 9 is applied to a substrate and then thermally converted, especially at temperatures of 120 to 450°C.

11. Process according to Claim 10, **characterized in that** the substrate is an Si or Si/SiO₂ wafer, a glass substrate or a polymer substrate, the latter preferably based on PET, PE, PEN, PEI, PEEK, PI, PC, PEA, PA or PP.

12. Process according to Claim 10 or 11, **characterized in that** the formulation is applied to the substrate by spin-coating, spraying, flexographic printing, gravure printing, inkjet printing, screen printing, pad printing or offset printing.

13. Process according to any one of Claims 10 to 12, **characterized in that** the semiconductive ZnO layer is aftertreated by at least one process step selected from an aftertreatment with reducing or oxidizing atmospheres, treatment with moisture, plasma treatment, laser treatment and UV irradiation.

14. Use of a formulation according to any one of Claims 1 to 9 for producing electronic components, especially for producing transistors, optoelectronic components and sensors.

15. Electronic component comprising at least one semiconductive ZnO layer which has been produced by one of the processes according to any of Claims 10 to 13.

## Revendications

1. Composition comprenant
a) au moins deux différents cubanes de ZnO, dont
i) au moins un cubane de ZnO se trouve à l'état solide dans les conditions SATP (standard de température et de pression ambiantes) et
ii) au moins un cubane de ZnO se trouve à l'état liquide dans les conditions SATP, et
b) au moins un solvant.

2. Composition selon la revendication 1, **caractérisée en ce que** le cubane de ZnO se trouvant à l'état solide dans les conditions SATP présente sous 10⁵ Pa un point de décomposition de 120 - 300 °C, de façon particulièrement préférée de 150 - 250 °C.

3. Composition selon la revendication 1 ou 2, **caractérisée en ce que** le cubane de ZnO se trouvant à l'état solide dans les conditions SATP est un cubane de ZnO de formule générale [R¹Zn(OR²)]₄ où R¹ = Me ou Et et R² = t-Bu ou i-Pr, en particulier [MeZn(O-t-Bu)]₄ ou [MeZn(O-i-Pr)]₄.

4. Composition selon l'une quelconque des revendications précédentes, **caractérisée en ce que** le cubane de ZnO se trouvant à l'état liquide dans les conditions SATP présente sous la pression normale un point de fusion de 25 à -100 °C, de façon particulièrement préférée de 0 à -30 °C.

5. Composition selon l'une quelconque des revendications précédentes, **caractérisée en ce que** le cubane de ZnO se trouvant à l'état liquide dans les conditions SATP est un cubane de ZnO de formule générale [R¹Zn (OR²)]₄ où R¹ = Me ou Et et R² = CH₂CH₂OCH₃, CH₂CH₂OCH₂CH₃, CH₂OCH₂CH₃, CH₂OCH₃ ou CH₂CH₂CH₂OCH₃, en particulier [MeZn (OCH₂CH₂OCH₃)]₄.

6. Composition selon l'une quelconque des revendications précédentes, **caractérisée en ce que** ledit au moins un cubane de ZnO solide sous la pression normale est présent en des proportions de 10 à 90 % en poids, de préférence de 30 à 70 % en poids, de façon tout particulièrement préférée de 40 à 60 % en poids, par rapport à la masse totale du cubane de ZnO solide et du cubane de ZnO liquide.

7. Composition selon l'une quelconque des revendications précédentes, **caractérisée en ce que** ledit au moins un solvant est choisi dans le groupe des solvants aprotiques ; de façon particulièrement préférée est choisi dans le groupe constitué par le toluène, le xylène, l'anisole, le mésitylène, le n-hexane, le n-heptane, la tris-(3,6-dioxaheptyl)-amine (TDA), le 2-aminométhyltétrahydrofurane, le phénétol, le 4-méthylanisole, le 3-méthylanisole, le benzoate de méthyle, la N-méthyl-2-pyrrolidone (NMP), la tétraline, le benzoate d'éthyle et l'oxyde d'éthyle.

8. Composition selon l'une quelconque des revendications précédentes, **caractérisée en ce que** la concentration des cubanes de ZnO vaut 5 - 60, de façon particulièrement préférée 10 - 50, de façon tout particulièrement préférée 20 - 40 % en poids, par rapport à la composition.

9. Composition selon l'une quelconque des revendications précédentes, **caractérisée en ce qu'**elle contient en outre 0,1 - 20 % en poids d'au moins un additif, par rapport aux cubanes de ZnO présents dans la composition.

10. Procédé pour la production d'une couche de ZnO semi-conductrice, **caractérisé en ce qu'**on applique sur un substrat une composition selon les revendications 1 à 9 et à la suite de cela on la convertit thermiquement, en particulier à des températures de 120 à 450 °C.

11. Procédé selon la revendication 10, **caractérisé en ce que** le substrat est une plaquette de Si ou de Si/SiO₂, un substrat en verre ou un substrat polymère, ce dernier de préférence à base de PET, PE, PEN, PEI, PEEK, PI, PC, PEA, PA ou PP.

12. Procédé selon la revendication 10 ou 11, **caractérisé en ce que** l'application de la composition sur le substrat s'effectue par spin-coating, pulvérisation, impression flexographique, impression en creux, impression par jet d'encre, sérigraphie, impression au tampon ou impression offset.

13. Procédé selon l'une quelconque des revendications 10 à 12, **caractérisé en ce qu'**on soumet la couche de ZnO semi-conductrice à un post-traitement par au moins une étape de processus choisie parmi un post-traitement par des atmosphères oxydantes ou réductrices, un traitement par l'humidité, un traitement par plasma, un traitement au laser et une irradiation UV.

14. Utilisation d'une composition selon l'une quelconque des revendications 1 à 9 pour la fabrication de composants électroniques, en particulier pour la fabrication de transistors, de composants optoélectroniques et de capteurs.

15. Composant électronique, contenant au moins une couche de ZnO semi-conductrice, qui a été produite conformément à l'un des procédés selon les revendications 10 à 13.
